Europäisches Patentamt

European Patent Office

Office européen des brevets

(19)

(11) Veröffentlichungsnummer : **0 573 866 B1**

(12) **EUROPÄISCHE PATENTSCHRIFT**

(45) Veröffentlichungstag der Patentschrift :
02.11.94 Patentblatt 94/44

(51) Int. Cl.$^5$ : **G03F 7/038,** C08G 73/10,
G03F 7/027

(21) Anmeldenummer : 93108737.3

(22) Anmeldetag : 01.06.93

(54) Verfahren zur Herstellung strukturierter Schichten wärmebeständiger Polykondensate.

(30) Priorität : 06.06.92 DE 4218718

(43) Veröffentlichungstag der Anmeldung :
15.12.93 Patentblatt 93/50

(45) Bekanntmachung des Hinweises auf die
Patenterteilung :
02.11.94 Patentblatt 94/44

(84) Benannte Vertragsstaaten :
AT BE CH DE FR GB IT LI NL SE

(56) Entgegenhaltungen :
EP-A- 0 203 372
FR-A- 2 280 925

(73) Patentinhaber : BASF Lacke + Farben
Aktiengesellschaft
Postfach 61 23
D-48136 Münster (DE)

(72) Erfinder : Blum, Rainer
Bannwasserstrasse 58
W-6700 Ludwigshafen (DE)
Erfinder : Haehnle, Hans-Joachim, Dr.
Prager Strasse 27
W-6700 Ludwigshafen (DE)
Erfinder : Hoffmann, Gerhard, Dr.
Pappelstrasse 22
W-6701 Otterstadt (DE)

(74) Vertreter : Karau, Wolfgang, Dr. et al
BASF Aktiengesellschaft,
Patentabteilung ZDX - C 6
D-67056 Ludwigshafen (DE)

## Beschreibung

Die Erfindung betrifft ein Verfahren zur Herstellung von strukturierten Schichten wärmebeständiger Polykondensate.

Strukturierte Schichten von wärmebeständigen Polykondensaten, z.B. für den Aufbau elektrischer Schaltungen, Schutz- bzw. Isolierschichten für elektronische Bauteile können hergestellt werden, indem

- lösliche, strahlungsempfindliche, d.h. ethylenisch ungesättigte Gruppen enthaltende Vorstufen der Polykondensate auf ein Substrat aufgetragen werden,
- die aufgetragene Schicht durch eine Negativvorlage zur Bildung einer (radikalisch) vernetzten, unlöslichen Zwischenstufe bestrahlt wird,
- die unbestrahlten, löslichen Teile entfernt werden und
- die nun strukturierte Schicht durch Tempern in das wärmebeständige Polykondensat überführt wird.

Als lösliche, strahlungsempfindliche Vorstufen der Polykondensate, z.B. Polyimide, werden entsprechende strahlungsempfindliche Prepolymere, z.B. Polyamidsäuren, eingesetzt.

Aus der DE-A-24 37 397 und der DE-A-34 11 697 ist bekannt, solche Prepolymeren durch Umsetzung von ethylenisch ungesättigten Tetracarbonsäureestern mit Diaminoverbindungen oder Diisocyanatverbindungen herzustellen. Nach der DE-A-24 37 397 wird dabei von den Säurechloriden der Tetracarbonsäureester ausgegangen, nach der DE-A-34 11 697 erfolgt die Umsetzung in Gegenwart eines Carbodiimids. Ein entsprechendes Verfahren zur Herstellung von strahlungsempfindlichen Polyamidsäuren ist in der US-A-4 551 522 beschrieben.

Nach den bisher bekannten Verfahren ist es daher notwendig zunächst in einem vorangestellten Verfahrensschritt lösliche, strahlungsempfindliche Vorstufen, d.h. Prepolymere für das oben beschriebene Verfahren herzustellen.

Prepolymere, z.B. Polyamidsäuren als strahlungsempfindliche Vorstufen haben zudem den Nachteil, daß die Lösungen der Prepolymeren und damit kondensierbaren Verbindungen durch die hohe Viskosität des Prepolymeren in ihrem Feststoffgehalt begrenzt sind und durch die Anwesenheit von reaktiven Endgruppen im allgemeinen eine geringe Lagerstabilität aufweisen.

Aufgabe der vorliegenden Erfindung war daher ein Verfahren, bei dem die Notwendigkeit zur Herstellung von Prepolymeren als Vorstufe entfällt.

Demgemäß wurde ein Verfahren zur Herstellung von strukturierten Schichten wärmebeständiger Polykondensate, dadurch gekennzeichnet, daß ethylenisch ungesättigte Tetracarbonsäureester oder Addukte oder Salze von Tetracarbonsäureestern, welche noch mindestens eine unveresterte Carbonsäuregruppe enthalten, mit ethylenisch ungesättigten Aminen, Amiden oder Oniumverbindungen im Gemisch mit Aminogruppen, Isocyanatgruppen oder blockierte Isocyanatgruppen enthaltenden Verbindungen, welche mit den Tetracarbonsäureestern polykondensierbar sind, als Schicht auf ein Substrat aufgetragen werden, diese Schicht durch eine Negativvorlage belichtet wird, anschließend die nicht belichteten, löslichen Stellen entfernt werden und die unlöslichen Stellen bei erhöhter Temperatur in die Polykondensatform überführt werden, gefunden.

Weiterhin wurden flüssige Gemische für dieses Verfahren gefunden, die ethylenisch ungesättigte Tetracarbonsäureester oder Addukte oder Salze von Tetracarbonsäureestern, welche noch mindestens eine unveresterte Carbonsäuregruppe enthalten, mit ethylenisch ungesättigten Aminen, Amiden oder Oniumverbindungen, mit den Tetracarbonsäureestern polykondensierbare Amino-, Isocyanatgruppen oder blockierte Isocyanatgruppen enthaltende Verbindungen und mindestens einem Fotoinitiator enthalten.

Die ethylenisch ungesättigten Tetracarbonsäureester und Addukte oder Salze von Tetracarbonsäureestern, welche noch mindestens eine unveresterte Carbonsäuregruppe enthalten, mit ethylenisch ungesättigten Aminen, Amiden oder Oniumverbindungen werden im weiteren zusammenfassend als strahlungsempfindliche Tetracarbonsäurederivate bezeichnet.

Beim erfindungsgemäßen Verfahren werden strahlungsempfindliche Tetracarbonsäurederivate im Gemisch mit damit polykondensierbaren Aminogruppen oder gegebenenfalls blockierte Isocyanatgruppen enthaltenden Verbindungen als Schicht auf ein Substrat aufgetragen.

Ethylenisch ungesättigte Tetracarbonsäureester können z.B. hergestellt werden durch Umsetzung von Tetracarbonsäuren oder deren Anhydride mit ethylenisch ungesättigten Alkoholen.

Als ungesättigte Alkohole seien z.B. Allylalkohol oder Hydroxyalkyl(meth)acrylate, insbesondere $C_2$-$C_6$-Hydroxyalkyl(meth)acrylate wie n-Hydroxy-ethyl(meth)acrylat, n-Hydroxypropyl(meth)acrylat und n-Hydroxybutyl(meth)acrylat genannt.

Weiterhin sind z.B. N-Hydroxymethyl(meth)acrylamid, Diethylenglykolmono(meth)acrylat, Zimtalkohol, Hydroxyalkylzimtsäureester und auch Alkohole mit mehreren ungesättigten Gruppen wie Glycerindi(meth)acrylat, Trimethylolpropandi(meth)acrylat und Pentaerythrittri(meth)acrylat, zu erwähnen.

Gegebenenfalls können auch ungesättigte Alkohole mit mehreren, z.B. zwei Hydroxylgruppen eingesetzt werden. Bevorzugt sind jedoch Monoalkohole.

Als Tetracarbonsäuren oder deren Anhydride kommen insbesondere aromatische oder teilaromatische Tetracarbonsäuren mit mindestens einem aromatischen Ring in Betracht. Es kann sich dabei um Tetracarbonsäuren mit einem aromatischen Ring, mit kondensierten aromatischen Ringsystemen oder aromatischen Ringen, die z.B. durch eine Einfachbindung, eine Ether-, Carbonyl-, Sulfonylgruppe oder aliphatische Kohlenstoffreste, insbesondere mit 1 bis 8 Kohlenstoffatomen und gegebenenfalls auch Heteroatomen wie Sauerstoff, Schwefel oder Stickstoff verbunden sind, handeln. Die aromatischen Ringe bzw. Ringsysteme können als Substituenten insbesondere $C_1$-$C_6$-Alkyl- oder -Alkoxygruppen oder Halogenatome, wie Chlor und Fluor tragen.

Beispielsweise zu nennen sind folgende Tetracarbonsäuren bzw. deren Anhydride.

Pyromellithsäure,

Benzol-1,2,3,4-tetracarbonsäure,

4,4-Veresterungs-, 4,4-Veretherungs- und 4,4-Amidisierungs dimere der Trimellithsäure,

3,3′,4,4′-Biphenyltetracarbonsäure,

2,2′,4,4′-Biphenyltetracarbonsäure,

2,3,3′,4′-Biphenyltetracarbonsäure,

3,3′,4,4′-Benzophenontetracarbonsäure,

2,2′,3,3′-Benzophenontetracarbonsäure,

2,3,3′,4′-Benzophenontetracarbonsäure,

2,3,6,7-Naphthalintetracarbonsäure,

1,2,5,6-Naphthalintetracarbonsäure,

1,2,4,5-Naphthalintetracarbonsäure,

1,4,5,8-Naphthalintetracarbonsäure,

1,2,6,7-Naphthalintetracarbonsäure,

2,6-Dichlornaphthalin-1,4,5,8-tetracarbonsäure,

2,7-Dichlornaphthalin-1,4,5,8-tetracarbonsäure,

2,3,6,7-Tetrachlornaphthalin-1,4,5,8-tetracarbonsäure,

1,4,5,8-Tetrachlornaphthalin-1,4,5,8-tetracarbonsäure,

4,8-Dimethyl-1,2,3,5,6,7-hexahydronaphthalin-1,2,5,6-tetracarbonsäure

4,8-Dimethyl-1,2,3,5,6,7-hexahydronaphthalin-2,3,6,7-tetracarbonsäure

4,4′-Oxydiphthalsäure,

3,3′-Oxydiphthalsäure,

4,4′-Sulfonyldiphthalsäure,

4,4′-Thiodiphthalsäure,

3,3′-Thiodiphthalsäure,

4,4′-Acetylidendiphthalsäure,

Bis(2,3-dicarboxyphenyl)methan

Bis(2,3-dicarboxyphenyl)methan

1,1-Bis(2,3-dicarboxyphenyl)ethan,

1,1-Bis(3,4-dicarboxyphenyl)ethan

2,2-Bis(2,3-dicarboxyphenyl)propan

2,2-Bis(3,4-dicarboxyphenyl)propan

Phenathren-1,2,7,8-tetracarbonsäure,

Phenathren-1,2,6,7-tetracarbonsäure,

Phenathren-3,4,5,6-tetracarbonsäure,

Phenathren-1,2,9,10-tetracarbonsäure,

2,3,9,10-Perylentetracarbonsäure,

3,4,9,10-Perylentetracarbonsäure,

2,3,8,9-Perylentetracarbonsäure,

4,5,10,11-Perylentetracarbonsäure,

4,5,10,12-Perylentetracarbonsäure,

3,3″,4,4″-p-Terphenyltetracarbonsäure,

2,2″,3,3″-p-Terphenyltetracarbonsäure,

2,3,3″,4″-p-Terphenyltetracarbonsäure,

Butan-1,2,3,4-tetracarbonsäure,

Cyclopentan-1,2,3,4-tetracarbonsäure,

Pyrrolidin-2,3,4,5-tetracarbonsäure,

Thiophen-2,3,4,5-tetracarbonsäure,

Pyrazin-2,3,5,6-tetracarbonsäure,

Tetrahydrofurantetracarbonsäure,

9-Brom-10-mercaptoanthracentetracarbonsäure,

2,6-Endovinylencyclohexan-1,2,4,5-tetracarbonsäure.

Zur Umsetzung mit dem ungesättigten Alkohol werden insbesondere die Tetracarbonsäureanhydride, bevorzugt Tetracarbonsäuredianhydride eingesetzt. Die Umsetzung verläuft schon bei geringen Temperaturen, insbesondere zwischen 40 und 80°C, gegebenenfalls in Gegenwart von Veresterungskatalysatoren, z.B. Dimethylaminopyridin mit gutem, im allgemeinen vollständigen Umsatz.

Bevorzugt werden 1 mol Tetracarbonsäuren bzw. deren Anhydride mit 1 bis 3 mol ungesättigtem Alkohol verestert, so daß 1 bis 3 ungesättigte Gruppen im Molekül vorhanden sind. Besonders bevorzugt ist der Tetracarbonsäurediester mit zwei ungesättigten Estergruppen.

Geht man von den Tetracarbonsäuredianhydriden aus, bildet sich zunächst der entsprechende Diester auch bei einem Überschuß des ungesättigten Alkohols.

Der Diester kann dann aus dem Gemisch isoliert werden oder im Gemisch zusammen mit dem überschüssigen Alkohol als Reaktivverdünner weiter verwendet werden.

Die nicht mit ungesättigtem Alkohol veresterten Carbonsäuregruppen können, falls gewünscht, auch noch mit anderen, gesättigten Alkoholen verestert werden.

Zu nennen sind beispielsweise $C_1$-$C_8$-Alkanole, Phenol, Benzylalkohol, Phenoxypropyl- oder Phenoxyethylalkohol sowie Polyalkoxyglykolether oder Polyoxyglykolester.

Geeignete strahlungsempfindliche Tetracarbonsäurederivate können auch erhalten werden, indem man Tetracarbonsäureanhydride zunächst mit gesättigten Alkoholen umsetzt, wobei jedoch mindestens eine, vorzugsweise zwei Carboxylgruppen unverestert bleiben. Die erhaltenen gesättigten Tetracarbonsäureester können dann mit ethylenisch ungesättigten Aminen, Amiden oder Oniumverbindungen Salze oder Addukte bilden.

Im Falle von ethylenisch ungesättigten Aminen sind tertiäre Amine bevorzugt. Diese bilden leicht mit den Carbonsäuregruppen entsprechende Salze. Als Amine kommen z.B. Ester von Alkylaminoalkylalkoholen mit ungesättigten Carbonsäuren wie Maleinsäure, Zimtsäure, Crotonsäure und insbesondere (Meth)acrylsäure in Betracht. Zu nennen sind beispielsweise: Diethylaminoethylmethacrylat, Dimethylaminoethylmethacrylat, Diethylaminoethylacrylat, Dimethylaminoethylacrylat, Diethylaminopropylmethacrylat, Diethylaminopropylacrylat, t-Butylaminoethylacrylat, t-Butylaminoethylmethacrylat, Dimethylaminoethylcinnamat, Dimethylaminopropylcinnamat, NN-Dimethylaminoethyl(meth)acrylamid, NN-Dimethylaminopropyl(meth)acrylamid, NN-Dihydroxyethylaminoethyl(meth)acrylamid, NN-Dihydroxyethylaminopropyl(meth)acrylamid, NN-Dimethylaminopropylmethacrylamid und NN-Dimethylaminopropylacrylamid.

Weitere geeignete Aminoverbindungen sind Allylamine, Alkylallylamine und cyclische oder heterocyclische Verbindungen wie Vinylpyridin und Alkylvinylpyridine. Diese Amine können allein oder als Mischungen eingesetzt werden.

Auch im Falle der ethylenisch ungesättigten Amide bilden sich mit Carbonsäuregruppen leicht Anlagerungskomplexe wie sie z.B. für N-Methylpyrrolidon mit Polyamidsäuren in Journal of Polymer Science, Part A, Polymer Chemistry, Vol. 25, 2005-2020 (1987) von M.J. Brekner und C. Feger beschrieben sind.

Als ethylenisch ungesättigte Amide zu nennen sind beispielsweise Acrylamid, Methacrylamid, N-Alkyl-(meth)acrylamide, wie N-Methyl(meth)acrylamid, N-Ethyl(meth)acrylamid, NN-Dialkyl(meth)acrylamide, wie NN-Dimethyl(meth)acrylamid, NN-Diethyl(meth)acrylamid, N-Alkyloxyalkyl(meth)acrylamide und N-(1,1-Dimethyl-3-oxobutyl)acrylamid (Diacetonacrylamid) und N-(Isobutoxymethyl)acrylamid.

Geeignet sind weiter auch die Metylolierungsprodukte von Acryl- und Methacrylamid und die etherartigen Kondensationsprodukte dieser Metylolierungsprodukte mit mono- oder polyfunktionellen Alkoholen. Weiter geeignet sind N-Vinyl-pyrrolidon, N-Acrylolyl-piperidin, N-Acrylolylmorpholin.

Auch Oniumsalze, welche mindestens eine copolymerisierbare, ethylenisch ungesättigte Gruppe aufweisen, können mit den Tetracarbonsäureestern, welche noch mindestens eine freie Carbonsäuregruppe aufweisen, Addukte bilden, so daß sich ein scrahlungsempfindliches Tetracarbonsäurederivat ergibt.

Als geeignete Oniumverbindungen sind beispielsweise Ammonium- oder Sulfoniumverbindungen zu nennen.

Als Ammoniumverbindungen kommen z.B. Quarternierungsprodukte von tertiären, ungesättigten Aminen mit ungesättigten Epoxiden, z.B. Glycidylmethacrylat in Betracht. Ebenso kann es sich auch um Quaternierungsprodukte der vorstehend genannten ungesättigten tertiären Amine mit gesättigten Epoxiden, z.B. Glycid oder anderen Quaternierungsmitteln, z.B. Alkyl- oder Alkenhalogeniden handeln.

Als Ammoniumverbindungen eignen sich auch Salze tertiärer Aminoverbindungen mit organischen Säuren, z.B. die entsprechenden Acetate, Formiate oder Maleinate.

Als Sulfoniumverbindungen sind insbesondere die Ternierungsprodukte von Thioethern geeignet.

In Betracht kommen z.B. die Ternierungsprodukte gesättigter und ungesättigter Thioether mit ungesättigten Epoxiden, wie Glycidyl(meth)acrylat oder die Ternierungsprodukte gesättigter und ungesättigter Thioether mit anderen Ternierungsmitteln, wie Alkylhalogeniden oder Alkenhalogeniden oder gesättigten Epoxiden wie Ethylenoxid und Glycid.

Die Quaternierung der tertiären Amine bzw. die Ternierung der Thioverbindungen wird mit dem Quaternierungs- bzw. Ternierungsmittel im allgemeinen bei Temperaturen zwischen 20 und 50°C in Gegenwart einer Säure durchgeführt. Die Nucleophilie des Säureanions sollte dabei so gering sein, daß es nicht mit der Oniumgruppe reagiert.

Als Säure zu nennen sind z.B. Essigsäure, Oxalsäure, aber auch ungesättigte Säuren wie Maleinsäure, Carbonsäure oder Zimtsäure. Auch die Tetracarbonsäureester, welche noch mindestens eine freie Carbonsäuregruppe haben, können bei der Quaternierung bzw. Ternierung als Säure eingesetzt werden.

Insgesamt enthalten die strahlungsempfindlichen Tetracarbonsäurederivate mindestens eine, vorzugsweise mindestens zwei ethylenisch ungesättigte Gruppen, welche durch Veresterung der Tetracarbonsäure bzw. deren Anhydrid mit einem ungesättigten Alkohol oder Salz- bzw. Adduktbildung von noch freien Carbonsäuregruppen eines Tetracarbonsäureesters mit ungesättigten Aminen, Amiden oder Oniumverbindungen in das Molekül eingeführt werden.

Besonders bevorzugt sind auch strahlungsempfindliche Tetracarbonsäurederivate, welche ein oder vorzugsweise zwei ungesättigte Estergruppen enthalten (Tetracarbonsäurediester) und zusätzlich noch ein Addukt oder Salz mit mindestens einem ungesättigten Amin, Amid oder einer ungesättigten Oniumverbindung bilden.

Bei den mit den oben beschriebenen strahlungsempfindlichen Tetracarbonsäurederivaten polykondensierbaren Aminogruppen oder Isocyanatgruppen enthaltenden Verbindungen handelt es sich insbesondere um im allgemieinen nicht ethylenisch ungesättigte Verbindungen mit mindestens zwei Isocyanat- oder Aminogruppen, insbesondere um Diaminoverbindungen oder die entsprechenden Diisocyanate, welche mit den Tetracarbonsäurederivaten zu Polyimiden kondensieren.

Die Isocyanatgruppen sollten blockiert sein, falls die Isocyanatverbindungen im Gemisch mit Tetracarbonsäureestern, welche noch freie Carboxylgruppen haben, vorliegen.

Blockierungsmittel für Isocyanatgruppen sind z.B. sek. Amine, Alkohole, bevorzugt aliphatische $C_1$-$C_5$-Alkohole, Phenol und insbesondere Ketoxime wie Methylethylketoxim.

Bevorzugt sind aromatische oder teilaromatische Diamine, welche mindestens einen aromatischen Ring enthalten. Es kann sich dabei um Diamine mit einem aromatischen Ring, mit kondensierten aromatischen Ringsystemen oder aromatische Ringen, die z.B. durch eine Einfachbindung, eine Ether-, Carbonyl-, Sulfonylgruppe oder aliphatische Kohlenwasserstoffreste, insbesondere mit 1 bis 8 Kohlenstoffatomen und gegebenenfalls auch Heteroatomen wie Schwefel, Stickstoff oder Sauerstoff, verbunden sind, handeln. Die aromatischen Ringe bzw. Ringsysteme können als Substituenten insbesondere $C_1$-$C_6$-Alkyl- oder -Alkoxygruppen oder Halogenatome wie Chlor und Fluor tragen.

Beispielsweise genannt seien:

p-Phenylendiamin,
m-Phenylendiamin,
4,4'-Diaminodiphenyloxid,
3,3'-Diaminodiphenyloxid,
3,4'-Diaminodiphenyloxid,
4,4'-Diaminodiphenylsulfid,
3,3'-Diaminodiphenylsulfid,
3,4'-Diaminodiphenylsulfid,
4,4'-Diaminodiphenylsulfon,
3,3'-Diaminodiphenylsulfon,
3,4'-Diaminodiphenylsulfon,
4,4'-Diaminodiphenylmethan,
3,3'-Diaminodiphenylmethan,
3,4'-Diaminodiphenylmethan,
(4,4'-Diaminodiphenyl)-propan,
(3,3'-Diamonidiphenyl)-propan,
(4,4'-Diaminodiphenyl)-ethan,
(3,3'-Diamonidiphenyl)-ethan,
4,4'-Bis(4,4'-aminophenoxy)-biphenyl,

4,4'-Bis(4,3'-aminophenoxy)-biphenyl,
2,2-Bis[4-(4,4-aminophenoxy)phenyl]-propan,
2,2-Bis[4-(4,4-aminophenoxy)phenyl]-perfluorpropan,
2,2-Bis[4-(3,4-aminophenoxy)phenyl]-propan,
2,2-Bis[4-(3,3'-aminophenoxy)phenyl]-propan,
2,2-Bis[4-(4,4'-aminophenoxy)phenyl]-sulfon,
2,2-Bis[4-(3,4-aminophenoxy)phenyl]-sulfon,
2,2-Bis[4-(3,3'-aminophenoxy)phenyl]-sulfon,
4,4'-Dimethyl-3,3'-diaminodiphenylsulfon,
2,2-Bis[4-(4,4'-aminophenoxy)phenyl]-sulfid,
2,2-Bis[4-(3,4-aminophenoxy)phenyl]-sulfid,
2,2-Bis[4-(3,3'-aminophenoxy)phenyl]sulfid,
2,2-Bis[4-(4,4'-aminophenoxy)phenyl]-methan,
2,2-Bis[4-(3,4-aminophenoxy)phenyl]-methan,
2,2-Bis[4-(3,3'-aminophenoxy)phenyl]-methan,
1,4-Bis-(4,4'-aminophenoxy)-phenylen,
1,4-Bis-(3,4'-aminophenoxy)-phenylen,
1,4-Bis-(3,3'-aminophenoxy)-phenylen,
4,4'-Diaminobenzanilid,
3,4'-Diaminobenzanilid,
3,3'-Diaminobenzanilid,
4,4'-Diaminodiphenyl (Benzidin),
3,4'-Diaminodiphenyl,
3,3'-Diaminodiphenyl,
3,3'-Dimethoxy-4,4'-diaminodiphenyl,
3,3'-Dimethoxy-3,4'-diaminodiphenyl,
3,3'-Dimethyl-4,4'-diaminodiphenyl,
3,3'-Dimethyl-3,4'-diaminodiphenyl,
1,8-Diaminonaphthalin,
1,5-Diaminonaphthalin,
p-Terphenyl-4,4''-diamin,
p-Terphenyl-3,3''-diamin,
5-tert.-Butyl-2,4-toluylendiamin,
3-tert.-Butyl-2,6-toluylendiamin,
3,5-Diethyl-2,4-toluylendiamin,
3,5-Diethyl-2,6-toluylendiamin,
$\alpha,\infty$-Diamino-(polyphenylensulfid)e,
m-Xylylendiamin,
p-Xylylendiamin,
Bis-4,4'-[(2,6-diisopropyl)aminophenyl]methan
Bis-4,4'-[(2-methyl-6-isopropyl)aminophenyl]methan,
Bis-4,4'-[(2,6-dimethyl)aminophenyl]methan,
Bis-4,4'-[(2,6-diisopropyl)aminophenyl]ether,
Bis-4,4'-[(2-methyl-6-isopropyl)aminophenyl]ether,
Bis-4,4'-[2,6-dimethyl)aminophenyl]ether,
Diamino-(dimethyl)-dicyclohexyl-methan,
Diamino-(dimethyl)-diisopropyl-dicyclohexyl-methan,
Diamino-(tetraisopropyl)-dicyclohexyl-methan,
Diamino-(diisopropyl)-dicyclohexyl-methan,
Diisopropyltoluylendiamin,
Alkyliso-propyl-toluylendiamin,
u.a.

Der Begriff "Diamine" soll auch Verbindungen umfassen, die das Strukturelement N-N enthalten, d.h. Abkömmlinge des Hydrazins sind.

Weitere wichtige Amine sind Tetraamine wie
3,3',4,4'-Tetraaminobiphenyl,
3,3',4,4'-Tetraaminodiphenylmethan,
3,3',4,4'-Tetraaminodiphenylether,

6

EP 0 573 866 B1

3,3′,4,4′-Tetraaminodiphenylsulfon,

3,3′,4,4′-Tetraaminodiphenylsulfid,

Tetraamine ergeben als Endstruktur bei der Umsetzung mit den Tetracarbonsäureestern Polyaroylenbenzimidazole.

Weiter sind die aromatischen Diamine die am Kern weiter mit reaktionsfähigen Gruppen substituiert sind von Bedeutung. Solche reaktionsfähigen Substituenten sind z.B. Carboxyl-, Hydroxyl- und Amidgruppen. Im Falle der o-Carbonsäureamidamine, wie z.B. des Anthranilsäureamids, ergeben sich als Endstruktur bei der Umsetzung mit den Tetracarbonsäureestern Polyisoindolochinazolindione.

Eine weitere Gruppe von Diaminen sind aromatische Mehrkernverbindungen die über Benzanilidgruppen verbunden sind, wie z.B. 3,3′-Diaminobenzanilid, 3,4′-Diaminobenzanilid, 4,3′-Diaminobenzanilid, 4,4′-Diaminobenzanilid, 4,3′-Diaminobenzanilid und die N-Alkylsubstitutionsprodukte dieser Anilide, sowie die α-Polyaniliddiamine nach EP 271 736.

Das zur Beschichtung der Substrate eingesetzte Gemisch enthält vorzugsweise 0,6 bis 1,5 Mol, besonders bevorzugt 0,9 bis 1,1 Mol einer Diaminoverbindung bzw. Diisocyanatverbindung, bezogen auf 1 Mol strahlungsempfindlichen Tetracarbonsäurederivate.

Weiterhin kann das Gemisch noch Lösemittel, vor allem zur Einstellung der Verarbeitungsviskosität enthalten.

Als Lösemittel kommen neben Alkoholen, Estern, Ketonen, Ethern und einfachen, insbesondere aromatischen Kohlenwasserstoffen insbesondere Lösemittel mit hoher Polarität in Betracht. Als solche zu nennen sind beispielsweise Formamid, Acetamid, N-Methylformamid, N,N-Dimethylformamid, N,N-Diethylformamid, N-Methylpyrrolidon, N,N-Dimethylacetamid, N,N-Diethylacetamid, Butyrolacton, Caprolactam, Pyrrolidon, Dimethylsulfoxid, Dimethylsulfon, Hexamethylenphosphorsäureamid, Dimethylpropylenharnstoff und Dimethylethylenharnstoff.

Beim erfindungsgemäßen Verfahren kann deutlich weniger Lösemittel verwendet werden als bei herkömmlichen Verfahren, welche von Prepolymeren als strahlungsempfindliche Vorstufen ausgehen. Die strahlungsempfindlichen Tetracarbonsäureester und damit polykondensierbaren Amino- oder Isocyanatverbindungen können aufgrund ihrer geringeren Viskosität mit deutlich höherem Feststoffgehalt verarbeitet werden. Es kann auch ganz auf Lösungsmittel verzichtet werden, falls die im allgemeinen festen Aminverbindungen oder Isocyanatverbindungen in den gegebenenfalls flüssigen Tetracarbonsäureestern löslich sind.

Weiterhin können die Gemische auch Reaktivverdünner enthalten, welche zur Erhöhung der Lichtempfindlichkeit eingesetzt werden. Gleichzeitig können die Reaktivverdünner als Lösungsmittel wirken. Reaktivverdünner sind einfach oder mehrfach ethylenisch ungesättigte Verbindungen. Als solche eignen sich z.B. die oben genannten ungesättigten Alkohole für die Veresterung der Tetracarbonsäuren.

Des weiteren können natürlich auch nicht hydroxyfunktionelle Reaktivverdünner, insbesondere auch die oben genannten ethylenisch ungesättigten Amino- oder Amidverbindungen eingesetzt werden.

Dem Gemisch wird weiterhin im allgemeinen mindestens ein Fotoinitiator zugesetzt.

Als Fotoinitiatoren genannt seien z.B. Benzophenone, Alkylbenzophenone, halogenmethylierte Benzophenone, Michlers Keton, Anthron und halogenierte Benzophenone. Ferner eignen sich Benzoin und seine Derivate. Ebenfalls wirksame Fotoinitiatoren sind Anthrachinon und zahlreiche seiner Derivate, beispielsweise β-Methylanthrachinon, tert.-Butylanthrachinon und Anthrachinoncarbonsäureester und Acylphosphinoxide, z.B. 2,4,6-Trimethylbenzoyldiphenylphosphinoxid (Lucirin® TPO).

Ihr Anteil beträgt im allgemeinen 0,1 bis 10, insbesondere 0,2 bis 5 Gew.-%, bezogen auf das Gemisch aus strahlungsempfindlichem Tetracarbonsäurederivat und Amino- bzw. Isocyanatverbindung und Reaktivverdünnern.

Der Gehalt an strahlungsempfindlichen Tetracarbonsäurederivaten, Amino- bzw. Isocyanatverbindung im Gemisch beträgt im allgemeinen 30 bis 80, bevorzugt 50 bis 70 Gew.-%, bezogen auf das gesamte Gemisch.

Zur Herstellung einer strukturierten Schicht wird das Gemisch auf eine Substratoberfläche, z.B. aus Silicium oder Siliciumdioxid oder Siliciumnitrid aufgetragen.

Vor der Belichtung findet im allgemeinen eine Vortrocknung statt, wodurch gegebenenfalls mitverwendete Lösemittel entfernt werden. Die Vortrocknung erfolgt vorzugsweise bei 30 bis 140°C, besonders bevorzugt bei 80 bis 120°C. Sie kann unter Luft, insbesondere aber unter Inertgasen, wie Stickstoff, oder im Vakuum durchgeführt werden. Die Dauer der Vortrocknung ist bevorzugt 5 bis 30 Minuten.

Anschließend wird die Schicht mit einer Negativvorlage z.B. einer Aluminiumfolie, in der die zu beschichtenden Stellen ausgespart sind, abgedeckt.

Durch die Bestrahlung mit energiereichem Licht, insbesondere UV-Licht werden die löslichen Vorstufen durch Dimer- oder Oligomerbildung der ethylenisch ungesättigten Gruppen in eine unlösliche bzw. schwerlösliche Zwischenstufe überführt.

Übliche Bestrahlungsdauern liegen bei UV-Lampen mit einer Strahlungsenergie von 10 bis 50 mJ/cm² zwi-

7

schen 10 und 120 Sekunden.

Nach der Bestrahlung kann gegebenenfalls noch eine Nachtrocknung, insbesondere bei 60 bis 120°C, bevorzugt bei 70 bis 100°C durchgeführt werden, um die Präzision der Strukturen zu verbessern.

Die Dauer beträgt bevorzugt 5 bis 10 Minuten.

Nachdem die Negativvorlage entfernt ist, können die nicht belichteten Stellen mit einem geeigneten Lösungsmittel ausgewaschen werden.

Schließlich wird die erhaltene, strukturierte Schicht bei hohen Temperaturen, insbesondere bei 300 bis 400°C ausgehärtet, d.h. die Polykondensation, im allgemeinen die Polyimidbildung, zwischen den Tetracarbonsäureestern und den Amino- und Isocyanatverbindungen durchgeführt. Die ungesättigten Alkohole sowie die ungesättigten Amin-, Amid- oder Oniumverbindungen bzw. deren Dimere oder Oligomere werden dabei abgespalten und entweichen.

Die erhaltenen strukturierten Schichten werden z.B. zum Aufbau elektronischer Schaltungen bzw. als Isolier- oder Schutzschichten für elektronische Bauteile verwendet.

Beispiele 1 bis 7

Herstellung von Gemischen aus ethylenisch ungesättigten Tetracarbonsäureester und Diaminoverbindung

Alle Arbeiten wurden in einem Labor mit UV-freiem Licht durchgeführt.

In einem Rührkolben mit Reinstickstoffspülung wurde das Lösemittel vorgelegt und dann die Tetracarbonsäureanhydride, die ungesättigte Hydroxyverbindung und ggf. der Veresterungskatalysator eingerührt.

Die Veresterung wurde bei ca. 70°C durchgeführt bis der Tetracarbonsäurediester entstanden war (ca. 1,5 Std.).

Der Veresterungsgrad wurde durch HPLC und potentiometrische Titration kontrolliert.

Bei Raumtemperatur wurde dann die Diaminoverbindung, Reaktivverdünner und Fotoinitiatoren zugegeben und in der Mischung gelöst.

Abkürzungen:

| | |
|---|---|
| ODPA | Oxidiphthalsäuredianhydrid |
| BTDA | Benzophenontetracarbonsäuredianhydrid |
| BAPP | 2,2-Bis[(4-aminophenoxy)phenyl]propan |
| S100 | Solvesso® 100 ($C_1$-$C_4$-Alkylbenzolgemisch der Firma Esso) |
| NMP | N-Methylpyrrolidon |
| DMAP | Dimethylaminopyridin |
| HEA | Hydroxyethylacrylat |
| HEMA | Hydroxyethylmethacrylat |
| BMA | Butandiolmonoacrylat |
| BDA | Butandioldiacrylat |
| ZA | Zimtalkohol |
| MAMOL | Methylolmethacrylamid |
| MAMOL-B | Methylolmethacrylamid-Butylether (43 % in Butanol) |
| MAMOL-P | Methylolmethacrylamid-Trimethylolpropantriether |
| LKV | Leuco-Kristallviolett (4,4′,4″-Tris[dimethylaminophenyl]methan |
| MAZ | N-(4-Azidosulfonylphenyl)maleinimid |
| BDK | Benzildimethylketal |

Beispiel 1

Lösemittel:

90,00 g NMP

Tetracarbonsäuredianhydrid:

0,05 Mol (16,15 g) BTDA
0,05 Mol (15,51 g) ODPA

ungesättigte Hydroxyverbindung:

0,3 Mol (34,8 g) HEA

Veresterungskatalysator:

0,50 g DMAP

Aminverbindung:

0,10 Mol (41,05 g) BAPP

Reaktivverdünner:

20,0 g HEA
32,0 g MAMOL-B

Fotoinitiator:

0,40 g LKV
8,00 g MAZ

Beispiel 2

Lösemittel:

90,0 g NMP

Tetracarbonsäuredianhydrid:

0,05 Mol (15,51 g) ODPA
0,05 Mol (16,15 g) BTDA

ungesättigte Hydroxyverbindung:

0,3 Mol (34,8 g) HEA

Veresterungskatalysator:

0,50 g DMAP

Aminverbindung:

0,10 Mol (41,05 g) BAPP

Reaktivverdünner:

-
-

Fotoinitiator:

0,35 g LKV
6,50 g MAZ

Beispiel 3

Lösemittel:

70,0 g NMP
20,0 g S 100

Tetracarbonsäuredianhydrid:

0,05 Mol (15,51 g) ODPA
0,05 Mol (16,15 g) BTDA

ungesättigte Hydroxyverbindung:

0,3 Mol (43,2 g) BMA

Veresterungskatalysator:

0,50 g DMAP

Aminverbindung:

0,10 Mol (41,05 g) BAPP

Reaktivverdünner:

20,0 g HEA
32,0 g MAMOL-B

Fotoinitiator:

0,40 g LKV
8,00 g MAZ

Beispiel 4

Lösemittel:

90,0 g NMP

Tetracarbonsäuredianhydrid:

0,05 Mol (15,51 g) ODPA
0,05 Mol (16,15 g) BTDA

ungesättigte Hydroxyverbindung:

0,3 Mol (40,2 g) ZA

Veresterungskatalysator:

0,50 g DMAP

Aminverbindung:

0,10 Mol (41,05 g) BAPP

Reaktivverdünner:

30,0 g HEA
20,0 g MAMOL-P

Fotoinitiator:

0,35 g LKV
6,50 g MAZ

Beispiel 5

Lösemittel:

90,0 g NMP

Tetracarbonsäuredianhydrid:

0,05 Mol (15,51 g) ODPA
0,05 Mol (16,15 g) BTDA

ungesättigte Hydroxyverbindung:

0,3 Mol (40,2 g) ZA

Veresterungskatalysator:

0,50 g DMAP

Aminverbindung:

0,10 Mol (41,05 g) BAPP

Reaktivverdünner:

30,0 g HEA
20,0 g MAMOL

Fotoinitiator:

0,35 g LKV
6,50 g MAZ

Beispiel 6

Lösemittel:

90,0 g NMP

Tetracarbonsäuredianhydrid:

0,05 Mol (15,51 g) ODPA
0,05 Mol (16,15 g) BTDA

ungesättigte Hydroxyverbindung:

0,15 Mol (40,2 g) ZA

Veresterungskatalysator:

0,50 g DMAP

Aminverbindung:

0,10 Mol (41,05 g) BAPP

Reaktivverdünner:

30,0 g HEA
20,0 g MAMOL

Fotoinitiator:

0,35 g LKV
10,00 g BDK

Beispiel 7

Lösemittel:

90,0 g NMP

Tetracarbonsäuredianhydrid:

0,05 Mol (16,15 g) BTDA
0,05 Mol (15,51 g) ODPA

ungesättigte Hydroxyverbindung:

0,3 Mol (39,0 g) HEMA

Veresterungskatalysator:

0,50 g DMAP

Aminverbindung:

0,10 Mol (41,05 g) BAPP
Diese Mischung (203,3 g) hatte einen Feststoffgehalt von 48,86 % und eine Viskosität von 2315 mPas bei 25°C.

Reaktivverdünner:

20,0 g HEA
32,0 g MAMOL-B

Fotoinitiator:

0,40 g LKV
8,00 T MAZ
Die gebrauchsfertige Zubereitung hatte einen Feststoffgehalt von 35,9 % und eine Viskosität von 1088 mPas.

Vergleichsbeispiel 1 (s. EP 203 372, Beispiel 1)

0,07 Mol (22,61 g) BTDA und

EP 0 573 866 B1

0,07 Mol (21,72 g) ODPA
wurden in 250 ml NMP unter trockenem Stickstoff bei Raumtemperatur unter Rühren gelöst, dann wurden
0,056 Mol (7,28 g) HEMA
zugegeben. Es wurde 1 Std. bei Raumtemperatur und 1 Std. bei 35°C gerührt und auf Raumtemperatur abgekühlt. Während 15 Minuten wurde dann eine Lösung von
0,112 Mol (45,97 g) BAPP in
100.00 ml NMP zugetropft.

Es wurde über Nacht bei Raumtemperatur gerührt und dann eine Lösung von
0,29 Mol (60,00 g) N,N-Dicyclohexylcarbodiimid in 120.00 ml NMP
zugetropft. Es wurde wieder über Nacht gerührt; dabei bildete sich ein Niederschlag von N,N-Dicyclohexylharnstoff. Danach wurden
92,00 g HEMA zugegeben.

Es wurde 5 Stunden bei 50°C und über Nacht bei Raumtemperatur gerührt, die Mischung wurde dann mit
80.00 ml Aceton
verdünnt und der Niederschlag abfiltriert. Das Filtrat wurde unter starkem Rühren in
2000.00 g deionisiertes Wasser eingetropft.

Dabei bildete sich ein gelbbrauner flockiger Niederschlag der abgenutscht wird. Der Nutschkuchen wird mit Wasser und dann mit Methanol gewaschen und im Vakuum getrocknet.

Das Polymere wurde in NMP gelöst. Die Lösung (insgesamt 203,3 g) hatte eine Viskosität von 72.800 mPas und einen Feststoffgehalt von 48,86 Gew.-%.

Dann wurden 20 g HEA und 32 g Mamol-B als Reaktivverdünner und 0,4 g LKV und 8 g MAZ als Photoinitiator zugesetzt.

Die gebrauchsfertige Zubereitung hatte einen Feststoffgehalt von 35,9 % und eine Viskosität von 31.650 mPas.

Tabelle 1

Vergleich von Beispiel 7 mit dem Vergleichsbeispiel 1

| Bei-spiel | Gebrauchsfertiger Lack | | Lagerstabilität (Verdoppelung der Viskosität) |
|---|---|---|---|
| | Festgehalt [%] | Viskosität [mPas] | |
| B7 | 35,9 | 1088 | > 500 Tage |
| VB | 35,9 | 31650 | 32 Tage |

Anwendungstechnische Prüfung der Beispiele 1 bis 7

Die Lacke wurden mit einer Rakel mit 50 µm Spalthöhe auf gereinigte Tiefziehbleche aufgerakelt. Die Vortrocknung wurde in einem Vakuumschrank auf einer beheizten Platte bei einer Temperatur von 90°C und einer Dauer von 10 Minuten durchgeführt. Zur Belichtung wurde ein Teil der Probe mit einer Aluminiumfolie abgedeckt. Die Belichtung erfolgte unter einer breitbandigen Quecksilberhochdrucklampe mit einem Emissionsmaximum bei einer Wellenlänge von ca. 360 nm und einer Energie von 22 mJ/cm² (gemessen in der Ebene der zu belichtenden Filme). Die Belichtungszeit war eine Minute bei 15 cm Abstand.

Nach der Belichtung erfolgte eine 10-minütige Wärmenachbehandlung auf einer Heizplatte bei 90°C. Zur Prüfung auf eine Löslichkeitsdifferenz zwischen dem belichteten und dem unbelichteten Teil der Probe wurde diese in einem Becherglas mit Magnetrührer, in einem Gemisch aus NMP/Ethanol 7:3 für 3 Minuten behandelt und mit Ethanol abgespült.

Bei allen Beispielen zeigte sich eine gute Löslichkeitsdifferenzierung, d.h. die unbelichteten Stellen waren abgelöst und die belichteten Stellen waren durch das Lösungsmittel nicht angegriffen worden.

Nach der Entwicklung wurden die Bleche in einen auf 50°C vorgeheizten, programmgesteuerten Ofen gelegt, mit einer Rate von 5°C/Minute auf 350°C geheizt, 30 Minuten bei dieser Temperatur gehalten, aus dem Ofen entnommen und auf Raumtemperatur abgekühlt.

Es wurden in allen Fällen biege- und kratzfeste Polyimidfilme erhalten, die die polyimidtypische, stark ausgeprägte Bande bei Wellenzahl 1777 im IR-Spektrum zeigen.

13

EP 0 573 866 B1

Beispiele 8 bis 13

Herstellung von Gemischen aus Addukten von Tetracarbonsäureestern mit ethylenisch ungesättigten Amino- oder Amidoverbindungen und Diaminoverbindungen.

Die Herstellung erfolgte wie in den Beispielen 1 bis 7. Die ethylenisch ungesättigte Amino- oder Amidoverbindung wurde in das Gemisch eingerührt.

Beispiel 8

(ungesättigter Ester + ungesättigtes Amin)

Lösemittel:

90,00 g NMP

Tetracarbonsäuredianhydrid:

0,05 Mol (15,51 g) ODPA
0,05 Mol (16,15 g) BTDA

ungesättigte Hydroxyverbindung:

0,30 Mol (39,00 g) HEMA

Veresterungskatalysator:

0,50 g DMAP

Aminverbindung:

0,10 Mol (41,05 g) BAPP

Reaktivverdünner:

20,86 g HEA

Ungesättigtes Amin:

0,20 Mol (31,14 g) N,N-Dimethylaminoethylmethacrylat

Fotoinitiator:

0,40 g LKV
8,00 g MAZ
Die gebrauchsfertige Zubereitung hatte einen Feststoffgehalt von 35,9 % und eine Viskosität von 2 300 mPas.

Beispiel 9

(gesättigter Ester + ungesättigtes Amin)
Wie in Beispiel 8, anstelle der ungesättigten Hydroxyverbindung wurde eine gesättigte Hydroxyverbindung eingesetzt.

gesättigte Hydroxyverbindung:

0,30 Mol (32,40 g) Benzylalkohol
Die gebrauchsfertige Zubereitung hatte einen Feststoffgehalt von 36,4 % und eine Viskosität von 2 550 mPas.

14

Beispiel 10

(ungesättigter Ester + ungesättigtes Amid)

Lösemittel:

90,00 g NMP

Tetracarbonsäuredianhydrid:

0,05 Mol (15,51 g) ODPA
0,05 Mol (16,15 g) BTDA

ungesättigte Hydroxyverbindung:

0,30 Mol (39,00 g) HEMA

Veresterungskatalysator:

0,50 g DMAP

Aminverbindung:

0,10 Mol (41,05 g) BAPP

Reaktivverdünner:

20,86 g HEA

Ungesättigtes Amid:

(wird nur eingerührt)
0,20 Mol (31,14 g) N-(iso-Butoxymethyl)acrylamid

Fotoinitiator:

0,40 g LKV
8,00 g MAZ
Die gebrauchsfertige Zubereitung hatte einen Feststoffgehalt von 35,9 % und eine Viskosität von 1 260 mPas.

Beispiel 11

(gesättigter Ester + ungesättigtes Amid)
Wie Beispiel 10, anstelle der ungesättigten Hydroxyverbindungen wurde eine gesättigte Hydroxyverbindung eingesetzt.

gesättigte Hydroxyverbindung:

0,30 Mol (32,40 g) Benzylalkohol
Die gebrauchsfertige Zubereitung hatte einen Feststoffgehalt von 36,4 % und eine Viskosität von 1 540 mPas.

Beispiel 12

(ungesättigter Ester + ungesättigtes Amid)

Lösemittel:

90,00 g NMP

Tetracarbonsäuredianhydrid:

0,05 Mol (16,15 g) BTDA
0,05 Mol (15,51 g) ODPA

ungesättigte Hydroxyverbindung:

0,30 Mol (39,00 g) HEMA (1,5fach äquivalent)

Veresterungskatalysator:

0,50 g DMAP

Aminverbindung:

0,10 Mol (41,05 g) BAPP

Ungesättigtes Amido (Methylolamidether:)

0,20 Mol (68,20 g) Methylolacrylamid-glyzerintriether

Fotoinitiator:

0,40 g LKV
8,00 g MAZ

Die gebrauchsfertige Zubereitung hatte einen Feststoffgehalt von 32,7 % und eine Viskosität von 1 970 mPas.

Beispiel 13

(gesättigter Ester + ungesättigter Methylolamidether)

Wie Beispiel 12, anstelle der ungesättigten Hydroxyverbindungen wurde eine gesättigte Hydroxyverbindung eingesetzt.

gesättigte Hydroxyverbindung:

0,30 Mol (32,40 g) Benzylalkohol

Die gebrauchsfertige Zubereitung hatte einen Feststoffgehalt von 33,6 % und eine Viskosität von 2 130 mPas.

Prüfung der Beispiele 8 bis 13

Die Lacke wurden mit einer Rakel auf gereinigte Tiefziehbleche aufgerakelt. Durch Vorproben wurde eine Rakelspalthöhe bestimmt, bei der nach der Vortrocknung eine Schichtdicke von ca. 20 μm resultierte. Die Beschichtungen wurden in einem Vakuumschrank auf einer beheizten Platte 30 min bei 110°C vorgetrocknet. Zur Belichtung wurde ein Teil der Probe mit einer Aluminiumfolie abgedeckt. Die Belichtung erfolgte unter einer breitbandigen Quecksilberhochdrucklampe mit einem Emissionsmaximum bei einer Wellenlänge von ca. 360 nm. Es wurden je vier Proben belichtet, mit steigender Belichtungsdauer von 15 s, 30 s, 45 s und 60 s bei 15 cm Abstand, Die Energie der Strahlung, gemessen bei einer Wellenlänge von ca. 360 nm in der Ebene der zu belichtenden Filme, betrug 22 mJ/cm². Nach der Belichtung erfolgte eine Wärmenachbehandlung von 3 min bei 90°C auf einer Heizplatte. Zur Prüfung auf eine Löslichkeitsdifferenz zwischen dem belichteten und dem unbelichteten Teil der Probe wurde diese in einem Becherglas mit Magnetrührer, in einem Gemisch aus NMP/Ethanol 73 (Volumenteile) für 3 min behandelt, (entwickelt), mit Ethanol abgespült und mit Luft trockengeblasen.

16

Die Lichtempfindlichkeit ist an dem Schichtdickenverlust im belichteten Teil der Probe (Hellabtrag) zu erkennen.

Als Maß für die Lichtempfindlichkeit gilt die Belichtungszeit, die notwendig ist, daß kein oder kein deutlicher Hellabtrag mehr festzustellen ist (Tabelle 1).

Die strukturierten Filme wurden anschließend wie oben beschrieben gehärtet.

In allen Fällen wurden biege- und kratzfeste Polyimidfilme erhalten, die die polyimidtypische, stark ausgeprägte Bande bei der Wellenzahl 1777 im IR Spektrum zeigten.

Tabelle 1: Hellabtrag

| Bsp. Nr. | Belich-tungs-zeit [s] | Hellabtrag von → auf [μm] | Anmerkungen |
|---|---|---|---|
| 8 | 15 | 27→22 | Restfilm weich |
| | 30 | 26→23 | Restfilm noch etwas weich |
| | 45 | 27→27 | Restfilm fest, nicht gequollen |
| | 60 | 27→27 | Restfilm fest, nicht gequollen |
| 9 | 15 | 27→22 | Restfilm weich |
| | 30 | 26→28 | Restfilm gequollen |
| | 45 | 28→28 | Restfilm fest, nicht gequollen |
| | 60 | 26→26 | Restfilm fest, nicht gequollen |
| 10 | 15 | 26→24 | Restfilm noch etwas weich |
| | 30 | 28→26 | Restfilm noch etwas weich |
| | 45 | 25→25 | Restfilm fest, nicht gequollen |
| | 60 | 27→26 | Restfilm fest, nicht gequollen |
| 11 | 15 | 26→29 | Restfilm gequollen, weich |
| | 30 | 28→32 | Restfilm gequollen, weich |
| | 45 | 27→27 | Restfilm fest, nicht gequollen |
| | 60 | 28→28 | Restfilm fest, nicht gequollen |
| 12 | 15 | 27→24 | Restfilm weich |
| | 30 | 26→26 | Restfilm weich |
| | 45 | 28→28 | Restfilm fest, nicht gequollen |
| | 60 | 26→26 | Restfilm fest, nicht gequollen |
| 13 | 15 | 26→27 | Restfilm weich |
| | 30 | 28→30 | Restfilm gequollen |
| | 45 | 30→30 | Restfilm fest, nicht gequollen |
| | 60 | 28→28 | Restfilm fest, nicht gequollen |
| VB 1 | 15 | 28→ 0 | alles abgelöst |
| | 30 | 23→14 | Restfilm sehr weich |
| | 45 | 25→18 | Restfilm weich |
| | 60 | 26→27 | Restfilm noch etwas weich |

Beispiele 14 bis 16

Herstellung von Gemischen aus Addukten von Tetracarbonsäureestern mit ethlenisch ungesättigten Oniumverbindungen und Diaminoverbindungen

Weitere Abkürzungen:

TGD    Thiodiglykol

GLY Glycidol 2,3 Epoxy-, 1-Hydroxypropan
GLYMA Glycidylmethacrylat
EO Ethylenoxid
HWME Hydrochinonmonomethylether

Beispiel 14

Zunächst wurde, wie vorangehend beschrieben, ein Tetracarbonsäurediester hergestellt:

Lösemittel:

90,00 g NMP

Tetracarbonsäureanhydrid:

0,05 Mol (16,15 g) BTDA
0,05 Mol (15,51 g) ODPA

ungesättigte Hydroxyverbindung:

0,20 Mol (26,60 g) HEMA

Veresterungskatalysator:

0,50 g DMAP
Nach der Veresterung wurde in situ durch Zugabe von:

ungesättigtes Amin:

0,10 Mol (15,70 g) N,N-Dimethylaminoethylmethacrylat

Quaternierungsmittei:

0,10 Mol (7,40 g) GLY und 3 stündigen Rühren eine Ammoniumverbindung hergestellt, die mit den verbleibenden Carbonsäuregruppen des Diesters ein Addukt bildete. Anschließend wurden wie oben beschrieben die weiteren Komponenten zugegeben:

Aminverbindung:

0,10 Mol (41,05 g) BAPP
die sich nach ca. 15 min löst, wobei die Temperatur auf 65°C ansteigt, es wird auf Raumtemperatur gekühlt und eingerührt.

Reaktivverdünner:

20,00 g HEA
32,00 g Mamol-B

Fotoinitiator:

0,40 T LKV
8,00 T MAZ

Beispiel 15

Es wurde wie bei Beispiel 14 verfahren, die Reaktion wurde jedoch in einem druckdichten Laborautoklaven durchgeführt. Nach Zugabe des ungesättigten Amins wurde der Autoklaven auf 2 mbar entgast, dann wurde EO bis zu einem Überdruck von 3 bar aufgepreßt und bei 50°C 4 Std. gerührt, wobei der Druck auf 1,3 bar abnimmt, es wurde entspannt, mit Stickstoff gespült und weiter wie bei Beispiel 1 verfahren.

Beispiel 16

Herstellung einer Sulfoniumverbindung:

79,4 g TDG, 184,6 g GLYMA, 0,18 g HQME und 60 g Essigsäure wurden bei Raumtemperatur gemischt und anschließend für 8 Stunden auf 40°C erwärmt. Danach war der Umsatz bezüglich der Essigsäure quantitativ (potentiometrische Titration mit Tetrabutylammoniumhydroxid). Die Ausbeute an Sulfoniumacetat betrug 75 % (potentiometrische Titration mit Perchlorsäure).

Herstellung der Zubereitung:

Anschließend wurde wie oben beschrieben die Mischung aus Tetracarbonsäureester und Diaminverbindung hergestellt und die Sulfoniumverbindung in diese Mischung eingerührt.

Lösemittel:

90,00 g NMP

Tetracarbonsäuredianhydrid:

0,05 Mol (15,51 g) ODPA
0,05 Mol (16,15 g) BTDA

ungesättigte Hydroxyverbindung:

0,15 Mol (17,40 g) HEA

Veresterungskatalysator:

0,50 g DMAP

Aminverbindung:

0,10 Mol (41,05 g) BAPP

ungesättigte Sulfoniumverbindung

65,00 g

Fotoinitiator:

0,35 g LKV
6,50 g MAZ

Die Prüfung der Beispiele 14 bis 16 erfolgte entsprechend der Prüfung der Beispiele 8 bis 13. Die Ergebnisse sind in Tabelle 2 aufgeführt.

Tabelle 2 Hellabtrag

| Bsp. Nr. | Belich- tungs- zeit [s] | Hellabtrag von → auf [μm] | Anmerkungen |
|---|---|---|---|
| 14 | 15 | 23→10 | Restfilm weich |
|    | 30 | 23→19 | Restfilm noch etwas weich |
|    | 45 | 25→24 | Restfilm fest |
|    | 60 | 22→22 | Restfilm fest |
| 15 | 15 | 24→18 | Restfilm noch etwas weich |
|    | 30 | 25→23 | Restfilm fest |
|    | 45 | 25→24 | Restfilm fest |
|    | 60 | 24→24 | Restfilm fest |
| 16 | 15 | 27→ 0 | alles abgelöst |
|    | 30 | 26→23 | Restfilm noch etwas weich |
|    | 45 | 27→27 | Restfilm fest |
|    | 60 | 26→26 | Restfilm fest |

**Patentansprüche**

1. Verfahren zur Herstellung von strukturierten Schichten wärmebeständiger Polykondensate, dadurch gekennzeichnet, daß ethylenisch ungesättigte Tetracarbonsäureester oder Addukte oder Salze von Tetracarbonsäureestern, welche noch mindestens eine unveresterte Carbonsäuregruppe enthalten, mit ethylenisch ungesättigten Aminen, Amiden oder Oniumverbindungen im Gemisch mit Aminogruppen, Isocyanatgruppen oder blockierte Isocyanatgruppen enthaltenden Verbindungen, welche mit den Tetracarbonsäureestern polykondensierbar sind, als Schicht auf ein Substrat aufgetragen werden, diese Schicht durch eine Negativvorlage belichtet wird, anschließend die nicht belichteten, löslichen Stellen entfernt werden und die unlöslichen Stellen bei erhöhter Temperatur in die Polykondensatendform überführt werden.

2. Verfahren nach Anspruch 1, wobei es sich bei den mit den Tetracarbonsäureestern polykondensierbaren Verbindungen um aromatische Diaminoverbindungen handelt.

3. Flüssige Gemische für die Herstellung von strukturierten Schichten wärmebeständiger Polykondensate, enthaltend ethylenisch ungesättigte Tetracarbonsäureester oder Addukte oder Salze von Tetracarbonsäureestern, welche noch mindestens eine unveresterte Carbonsäuregruppe enthalten, mit ethylenisch ungesättigten Aminen, Amiden oder Oniumverbindungen, mit den Tetracarbonsäureestern polykondensierbare Amino-, Isocyanatgruppen oder blockierte Isocyanatgruppen enthaltende Verbindungen und mindestens einen Fotoinitiator.

4. Mit einem Gemisch nach Anspruch 3 beschichtete Substrate.

**Claims**

1. A process for the production of a structured layer of a heat-resistant polycondensate, wherein ethylenically unsaturated tetracarboxylates or adducts or salts of tetracarboxylates, which still contain at least one unesterified carboxylic acid group, with ethylenically unsaturated amines, amides or onium compounds mixed with compounds which contain amino, isocyanate or blocked isocyanate groups and can be subjected to polycondensation with the tetracarboxylates are applied as a layer to a substrate, this layer is exposed through a negative, the unexposed, soluble parts are then removed and the insoluble parts are converted into the final polycondensate form at elevated temperatures.

2. A process as claimed in claim 1, wherein the compounds which can be subjected to polycondensation with the tetracarboxylates are aromatic diamino compounds.

3. A liquid mixture for the production of a structured layer of a heat-resistant polycondensate containing ethylenically unsaturated tetracarboxylates or adducts or salts of tetracarboxylates, which still contain at least one unesterified carboxylic acid group, with ethylenically unsaturated amines, amides or onium compounds, compounds which can be subjected to polycondensation with the tetracarboxylates and contain amino, isocyanate or blocked isocyanate groups, and at least one photoinitiator.

4. A substrate coated with a mixture as claimed in claim 3.

**Revendications**

1. Procédé de fabrication de couches structurées de polycondensats résistants à la chaleur, caractérisé par le fait que l'on applique, comme couche, sur un substrat, des esters d'acides tétracarboxyliques non saturés éthyléniquement ou des produits d'addition ou des sels d'esters d'acides tétracarboxyliques, qui contiennent encore au moins un groupe d'acide carboxylique non estérifié, avec des amines, amides ou dérivés d'onium insaturés éthyléniquement, en mélange avec des composés contenant des groupes amino, des groupes isocyanate ou des groupes isocyanate bloqués, qui sont polycondensables avec les esters d'acides tétracarboxyliques, cette couche appliquée est exposée à un modèle négatif, ensuite les zones solubles non exposées sont éliminées et les zones insolubles sont mises, par température élevée, sous la forme de polycondensats.

2. Procédé selon la revendication 1, s'agissant pour les composés polycondensables avec les esters d'acides tétracarboxyliques, de composés diamino aromatiques.

3. Mélange liquide pour la fabrication de couches structurées de polycondensats résistants à la chaleur contenant des esters d'acides tétracarboxyliques non saturés éthyléniquement ou des produits d'addition ou des sels d'esters d'acides tétracarboxyliques, qui contiennent encore au moins un groupe d'acide carboxylique non estérifié, avec des amines insaturées éthyléniquement, amides ou dérivés d'onium avec des composés contenant des groupes amino, des groupes isocyanate ou des groupes isocyanate bloqués, qui sont polycondensables avec les esters d'acides tétracarboxyliques, et au moins un photoinitiateur.

4. Substrats enduits d'un mélange selon la revendication 3.